(19) Europäisches Patentamt / European Patent Office / Office européen des brevets

(11) EP 2 369 769 A2

(12) **EUROPEAN PATENT APPLICATION**

(43) Date of publication:
28.09.2011 Bulletin 2011/39

(51) Int Cl.:
*H04L 1/00* (2006.01)

(21) Application number: 11152956.6

(22) Date of filing: 01.02.2011

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(30) Priority: 12.02.2010 DE 102010007949

(71) Applicant: Deutsches Zentrum für Luft- und
Raumfahrt e.V.
51147 Köln (DE)

(72) Inventor: Boussemart, Vincent
81241, München (DE)

(74) Representative: von Kreisler Selting Werner
Deichmannhaus am Dom
Bahnhofsvorplatz 1
50667 Köln (DE)

(54) **Method of transmitting data**

(57) The invention is related to a method of transmitting data from a transmitter to a receiver in particular in a DVB-scenario. Hereby data is transmitted in consecutive bursts and each burst comprises a plurality of Multi-Protocol Encapsulation (MPE) sections and additionally Multi-Protocol Encapsulation - inter-burst-Forward Error Correction (MPE-iFEC) sections and / or Multi-Protocol Encapsulation- Forward Error Correction (MPE-FEC) sections. The content of the transmitted MPE-sections and MPE-iFEC or MPE-FEC sections is mapped into an Application Data Sub-Table (ADST) and an inter-burst-Forward Error Correction Data Sub-Table (iFDST) or Forward Error Correction Data Sub-Table (FDST) respectively. The content of the ADST and iFDST is mapped into ADT's and iFDTS's respectively as far as MPE- and MPE-iFEC sections are concerned. The decoding process is applied on a particular set of ADT and iFDT for MPE- and MPE-iFEC sections and on the ADST and FDST for MPE and MPE-FEC sections and after the decoding was performed on a particular set of ADT and iFDT the data part is copied back into ADST's.

According to the invention the ADT and iFDT or ADST and FDST on which decoding shall be applied is divided into several subblocks before being decoded, each subblock containing one or more lines of the ADT and iFDT or ADST and FDST. Each subblock is then forwarded to the decoder, so that decoding is applied on this subblock, whereby the decoder computes the column status for each subblock, namely the total number of erroneous or missing columns in this subblock and decides whether the content of each subblock can be decoded or not based on the column status of this subblock.

Fig.6

EP 2 369 769 A2

**Description**

The invention is related to a method of transmitting data from a transmitter to a receiver, in particular in a DVB-Scenario,

In the following different mechanisms and optimizations that can be used preferably in Multi-Protocol Encapsulation (MPE) - inter-burst Forward Error Correction (iFEC) Receivers for decoding are presented.

The transmission of data is performed according to "Digital Video Broadcasting (DVB); DVB specification for data broadcasting, ETSI EN 301 192 V1.4.2, April 2008" in bursts: an amount of data is inserted in the physical layer according to a given duration. On the one hand Multi-Protocol Encapsulation - Forward Error Correction was defined in order to add redundancy information within a given burst. The content of the burst is protected and if some losses occur data can be recovered. MPE-FEC is able to recover from fade events which are in the order of hundreds milliseconds. MPE-FEC is used for instance in Digital Video Broadcasting - Terrestrial (DVB-T) as described in "Framing structure, channel coding and modulation for digital terrestrial television, ETSI EN 300 744 V1,6.1, Jan. 2009". On the other hand, when considering a reception using a satellite segment fade events become more critical. Shadowing can occur (element between the satellite and the terminal) and the duration and the frequency of the fade events depend on the terminal position. When considering a mobile terminal fade events are in the order of several seconds. As specified previously MPE-iFEC means MPE - inter-burst FEC, i.e. the redundancy is computed and distributed over several time-slice bursts and this directly increases the interleaver duration. When MPE-FEC is able to recover fade events which are in the order of hundred milliseconds, MPE-iFEC can recover fade events which are in the order of several seconds.

MPE-iFEC is used for receiving data on a mobile terminal while using a satellite transmission. The corresponding standard is the Digital Video Broadcasting - Satellite Handheld (DVB-SH) as described in "Framing Structure, channel coding and modulation for Satellite Services to Handheld devices (SH) below 3 GHz, ETSI EN 302 583 V1.1.1, July 2007" and will be considered from now on in the present application.

The state of the art according to "Guidelines for Implementation for Satellite Services to Handheld devices (SH) below 3GHz", ETSI TS 102 584 V1.1.1, Dec. 2008 and MPE-IFEC, Draft TS 102 772 V1.1.1, DVB BlueBook A131, Nov. 2008, describes a Reed Solomon (RS) decoder (255,191) integrated in an MPE-iFEC receiver. When receiving a burst the MPE-iFEC Receiver analyses its content. A burst is composed of MPEG-TS packets which encapsulate different sections. These sections can contain data (MPE sections) or redundancy (MPE-FEC or MPE-IFEC sections). It is considered that a burst is composed of both MPE sections and MPE-iFEC sections. The burst thus contains data and redundancy which is computed from interleaved data and distributed over several bursts.

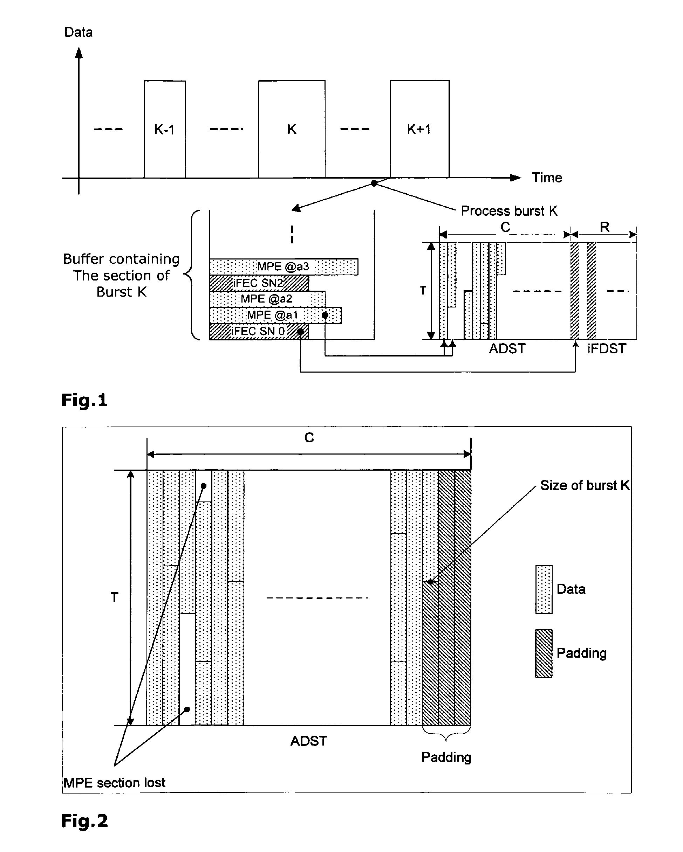

Next the mapping of the burst into ADST and iFDST is described. Once the burst is correctly detected, the MPE-iFEC Receiver has to extract the sections and to distribute the content of each section (that is the payload) into the tables. The data part (encapsulated in the MPE sections) has to be placed into the Application Data Sub-Table (ADST) and the redundancy part (encapsulated in the MPE-iFEC sections) in the iFEC Data Sub-Table (iFDST) (Figure 1).

MPE sections carry in their headers information about the address. The address corresponds to the position of the MPE section payload (more particularly the first byte) into the ADST as described in "MPE-IFEC, Draft TS 102 772 V1.1.1, DVB BlueBook A131, Nov. 2008". It permits to determine the column and the row at which the payload should be placed. The address field of the MPE section header is useful since some MPE sections may be lost within a bursts.

The MPE-iFEC Receiver thus processes all the MPE sections of a burst and places their content (payload) into the ADST according to the address indicated by the header. The size of the ADST is determined by the parameters C and T which are respectively the maximum number of data columns per ADST and the symbol size of code (number of rows).

In the example given by Figure 1 the MPE section having the address "al" ("MPE @ al") is mapped at the beginning of the ADST. The next MPE section has the address "a2" ("MPE @ a2") is not mapped directly after the first section: one or several MPE sections were lost and a gap appears in the ADST.

MPE-iFEC sections further carry in their headers information about the section number. The section number allows the receiver to determine the position of the MPE-iFEC section payload into the iFDST. The section number indicated by the MPE-iFEC section header is useful since some MPE-iFEC sections may be lost within a burst.

The MPE-iFEC Receiver thus processes all the MPE-iFEC sections of a burst and places their content (payload) into the iFDST according to the section number indicated by the header. The size of the iFDST is determined by the parameters R and T which are respectively the maximum number of iFEC sections in an iFEC burst and the symbol size of code (number of rows). Actually the payload size of the MPE-iFEC sections corresponds directly to the parameter T meaning that the content is completely placed into a column of the iFDST.

In the example depicted by Figure 1 the first iFEC section has the sequence number "0" which indicates to the Receiver that it has to be placed in the first column of the iFDST. The next MPE iFEC has the sequence number "2", it is thus placed into the third column of the iFDST: an iFEC section is missing and a gap appears in the iFDST.

The data part of a burst is not necessarily completely flled. This is mainly due to the time limitation related to the burst construction. For this reason the beginning of the Application Data Sub-Table (ADST) is filled but not necessarily the end.

Therefore, a padding containing no data is present in the ADST. The burst size of a burst is indicated by the previous burst size field present in the header of each MPE-iFEC section present in different bursts. If the burst size of a burst is known, the size of the padding within the burst, namely the data-free area, is known. Therefore, it is possible to recover the padding information so that the MPE-iFEC Receiver can fill the last columns of the ADST with padding (Figure 2).

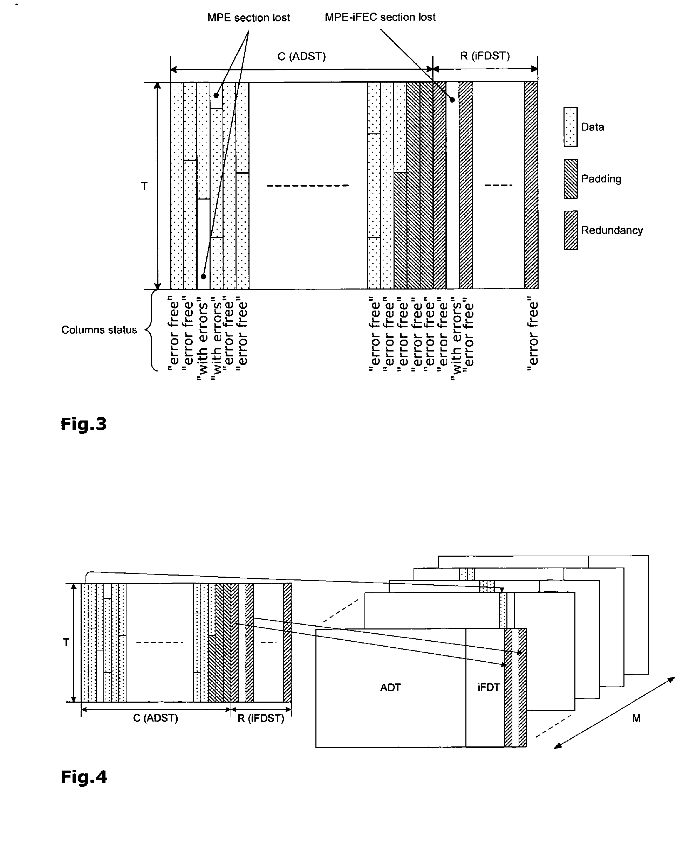

When the content of all MPE sections and MPE-iFEC sections is placed respectively into the ADST and the iFDST, and optionally the padding (if the size of the current burst is known), the MPE-iFEC Receiver determines the status of each column which can be "error free" and "with errors". If a column was completely filled then its status is "error free". On the contrary if a column was not completely filled then information is missing and its status is "with errors" (Figure 3).

Next the mapping of the ADST and iFDST into ADT's and IFDT's is described. Once all the sections received during the burst are mapped into the ADST and the iFDST each column of the two tables are respectively mapped in the Application Data Tables (ADTs) and the iFEC Data Tables (iFDTs). The number of ADT and iFDT depends on the parameter M which is defined as the number of concurrent ADT and iFDT (Figure 4).

The content of each column of the ADST is copied into different columns of the ADTs. The index $III$ of the ADT (there are $M$ ADTs) is computed using a formula which depends on the current datagram burst number $k$, the column index $J$ to be mapped, the parameter $B$, that is the iFEC data interleaving parameter, and the parameter $M$. $m=(k+j[B])[M]$ where $[\ ]$ is the modulo operator.

The column index $(adt\_column)$ of the ADT in which the current column $j$ of the ADST has to be placed is obtained using a formula taking into account the parameter $B$, the parameter $C$ and the current column index $j$,

$$adt\_column = \left(B - \left(j[B] + 1\right)\right) \times \lfloor C/B \rfloor + \max\left(0, C[B] - \left(j[B] + 1\right)\right) + \lfloor j/B \rfloor$$

where $[\ ]$ is the floor operator and $\max(\ )$ the maximum operator.

The content of each column of the iFDST is copied into different columns of the iFDTs. The index $m$ of the iFDT (there are $M$ iFDTs) is computed using a formula which depends on the current burst number $k$, the column index $j$ to be mapped, the parameter $S$, that is the iFEC spread parameter, and the parameter $M$. $m=(k-j[S]-1+M)[M]$ where $[\ ]$ is the modulo operator.

The column index of the iFDT in which the current columns $j$ of the iFDST has to be placed is $j$ directly.

The MPE-iFEC Receiver also copies the status of the columns while mapping the ADST and the iFDST into ADTs and iFDTs. In that way the Reed-Solomon decoder can determine before starting the decoding process what is the column error pattern in the input matrices (which is a given ADT and iFDT).

As soon as the content of both ADST and iFDST is copied into different ADTs and iFDTs both Data Sub-Tables can be cleaned in order to receive the content of another burst. All rows of each column in both tables are thus reset so that it does not contain information from previous bursts. The status of each column is also reset and assumed as "with errors" by default.

Next the decoding process is described. The decoding process is performed on a particular set of ADT and iFDT (thus on a specific index of the M ADTs and iFDTs). The content of the ADT corresponds to the data part and the content of the iFDT to the redundancy part.

The Reed-Solomon decoder used in the MPE-iFEC Receiver (RS (255, 191)) is able to recover completely from errors if and only if the number of columns "with errors" in the input matrices is smaller or equal to the number of redundancy columns which is 255 - 191 = 64. If the number of erroneous column is thus smaller or equal to 64 the RS decoder will be able to recover all columns "with errors" and mark them as "error free". On the contrary if the number of erroneous column is greater than 64 then the decoding process does not need to be started since the RS decoder will not be able to recover from errors. In that case the content of the columns is unchanged and their status also.

Once the decoding processed was performed on a given set of ADT and iFDT the data part can be copied back into ADSTs.

Actually at the transmission side the data to be sent was distributed among B ADTs, B being the iFEC data interleaving parameter. The content of the current ADT was thus issued from B ADSTs. For this reason at the receiver side the content of the ADT has to be distributed back into B ADSTs.

The same principle as for mapping the content of the ADST to ADTs is used: the content of each column of the ADT is copied into different columns of B ADSTs. The status of each column is also copied so that the Receiver can determine the error pattern of the output ADST.

After having mapped the content of the ADT the corresponding set of ADT and iFDT is cleaned so that it can receive the content of other bursts. All rows of each column in both tables are thus reset to that it does not contain information from previous bursts. The status of each column is also reset and assumed as "with errors" by default.

Next the processing of the ADST is described. Once an ADST was filled by B ADTs, it is selected among the B ADSTs available in order to be processed, i,e. so that the content of the ADST can be extracted. The ADST contains the original data that was transmitted and possibly recovered from errors. The ADST generally contains data in a specific format that allows the Receiver to take out easily (IP packets for instance).

The output ADST can contain data packets, for example IP packets. In such a case the content of the IP header allows the Receiver to determine the length of the IP packet so that it can continue extracting the rest of the ADST.

The present invention can also be applied if MPE-FEC sections are considered instead of MPE-iFEC sections. In that case the content of the ADST and FDST will be decoded, meaning that the above mentioned mapping into different tables will not take place. The FEC Data Sub-Table (FDST) contains the FEC sections associated with the MPE-sections of a given burst.

The problem considered in the present application is related to the decoding which is performed on a particular set of ADT and iFDT or ADST and FDST. Actually once the index is computed (there are M ADTs and iFDTs) the whole ADT and iFDT are given as input to the Reed-Solomon decoder. The RS decoder will first check the status of each column in order to determine whether it will be possible to decode and recover missing data or not, If the number of columns "with errors" is greater than the total number of redundancy columns (i.e. 64 here) then the decoding process is cancelled. On the contrary if the number of columns "with errors" is smaller or equal to 64 then the decoding process can continue and missing data will be recovered.

The status of each column, as described previously, widely depends on the error pattern. In MPE-iFEC Receivers the errors are not at the bit / byte level but at the packet level. Actually the physical layer is responsible for setting the transport error indicator in the MPEG-TS packets. If an MPEG-TS packet is marked as wrong then the MPE sections (MPE and / or MPE-iFEC) encapsulated into the corresponding MPEG-TS packet (part of one or several MPE sections) will be discarded by the Receiver. Moreover if for some reasons bits are corrupted between the transmission and the reception the Receiver will be able to detect such error (CRC check for instance) and will discard the corresponding MPE sections. The errors seen by the Receiver are thus packet errors: either the MPE section is correct and its payload is mapped into the ADST / iFDST or it is wrong and discarded. The ADST / iFDST can thus contain gaps (missing sections) which depend on the error pattern. The gaps are then distributed into the ADTs / iFDTs and are present at the input of the decoding process.

The status of each column ("with errors" or "error free") is based on the number of bytes filled when mapping the content of the burst into the ADST and the iFDST. If the number of bytes filled does not correspond to the size of the column (which is defined by the parameter "T") then the column is marked as "with errors". This means that if only some bytes are missing in a given column then the whole column is marked as "with errors". One can understand the impact it can have on the decoding process.

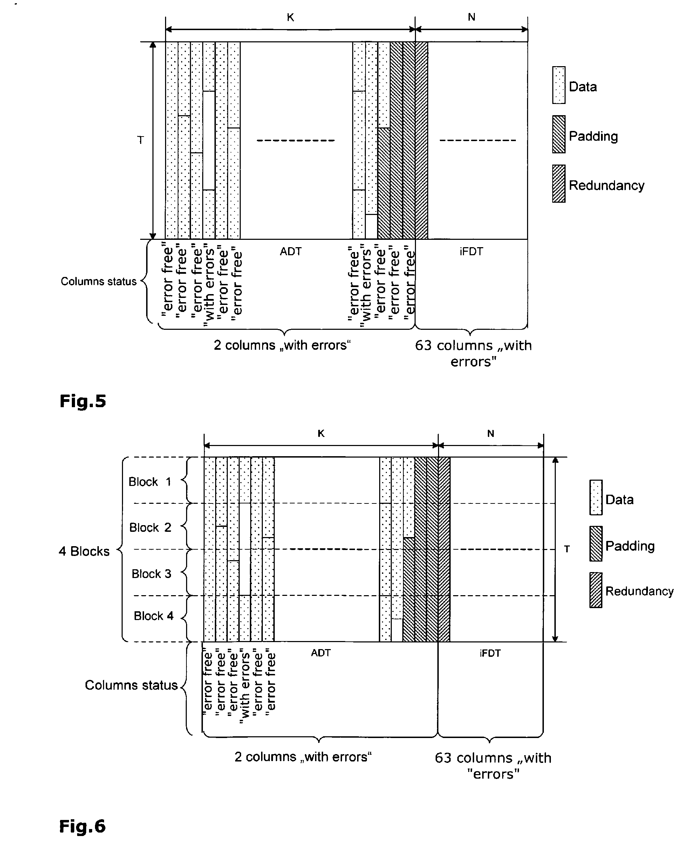

Figure 5 gives an example of the impact the error pattern can have on the decoding process. In this example a complete MPE section is missing in the fourth column, a part or a complete MPE section is also missing at the end of the ADT. All other columns are considered as "error free" in this ADT meaning that finally 2 columns are wrong in the Application Data Table. It is assumed in the example that all but the first MPE-iFEC section are missing (there is one MPE-iFEC section payload per column in the iFDT). In the iFDT 63 columns are thus missing. The total number of columns which are "with errors" is thus 2 + 63 = 65. Since this number is greater than 64 the decoding process will be aborted: the decoder cannot recover missing data. This whole set of ADT / iFDT is not processed because of the error pattern.

It is an object of the present invention to provide for a method of transmitting data from a transmitter to a receiver in particular in a DVB-scenario whereby the capability of recovering data during the decoding process is improved.

According to the present invention this object is achieved by the features of claim 1.

As can be seen in figure 5 the columns present in the ADT are not completely wrong but only partly wrong. The error pattern can be completely different than the one given in this example but in all cases columns that partly contain errors are considered as completely wrong. This impacts directly the capability of the receiver to recover from errors.

Therefore in the method according to the invention for transmitting data from a transmitter to a receiver the following method steps are applied:

Data is transmitted in consecutive bursts and each burst comprises a plurality of Multi-Protocol Encapsulation (MPE) sections and additionally Multi-Protocol Encapsulation-inter-burst Forward Error Correction (MPE-iFEC) sections and/or Multi-Protocol Encapsulation-Forward Error Correction (MPE-FEC) sections. The content of the transmitted MPE-sections and MPE-iFEC or MPE-FEC sections is mapped into an Application Data Sub-Table (ADST) and an inter-burst-Forward Error Correction Data Sub-Table (iFDST) or Forward Error Correction Data Sub-Table (FDST) respectively. The content of the ADST and iFDST is mapped into ADT's and iFDT's respectively as far as MPE and MPE-iFEC sections are concerned. The decoding process is applied on a particular set of ADT and iFDT for MPE and MPE-iFEC sections and on the ADST and FDST for MPE and MPE-FEC sections. After the decoding was performed on a particular set of ADT and iFDT the data part is copied back into ADST'S.

According to the invention the ADT and iFDT or ADST and FDST on which decoding shall be applied is divided into several subblocks before being decoded, each subblocks containing one or more lines of the ADT and iFDT or ADST and FDST. Each subblock is then forwarded to the decoder so that decoding is applied on this subblock. Hereby the decoder computes the column status for each subblock, namely the total number of erroneous or missing columns in this subblock. The decoder now decides whether the content of each subblock can be decoded or not based on the column status of this subblock. Since one decoding pass has to be performed per subblock, the number of subblocks will directly impact the processing time in the Receiver. The number of subblocks thus depends on the capability (in terms of computation power) of the Receiver.

Therefore in the Block Decoding method according to the invention the content of the ADT and iFDT or ADST and FDST is split into several subblocks which contain a part of the ADT/iFDT or ADST/FDST respectively. Each block is then forwarded to the decoder e.g. to a Reed Solomon decoder, which will perform the same decoding process as usual. The inventive mechanism has thus no impact on the decoder but only on the data given as input to the decoder. Thus the inventive method will improve the capability to recover data but will require more passes, meaning that the decoding process will be called more often than without Block Decoding. Without Block Decoding for each burst the decoding process is called only once.

It is preferred that each subblock contains the same number of lines which depends on the parameter T, namely the total size of the columns of the ADT and iFDT or ADST and FDST and further on the number n of subblocks considered. Thus the decoding process will be called n times instead of once. In other words for decoding the entire ADT and iFDT or ADST and FDST the decoding process is initiated n times.

In a preferred embodiment of the invention the total number of errors in each line of the ADT and iFDT or ADST and FDST is checked in order to decide if this line can be decoded or needs to be decoded. If the number of errors in a line is null, then the data part of this line is correct, so that there is no need to decode it. In this case the number of correct bytes will be equal to the parameter K. On the other side if the number of errors in a line is not null (or the number of correct bytes is not equal to the parameter K) then the rest of the line has to be checked. In that case the number of errors in each column in the corresponding line of the iFDT is also checked. This means that otherwise the corresponding line of the iFDT does not have to be checked so that only the ADT (or ADST respectively) has to be considered.

If the total number of errors is greater than the parameter N then this line cannot be decoded since there are too many errors. Instead of checking the errors present in a line it is possible to reciprocally check the number of bytes that are correct.

Thus the described method steps reside in dividing into subblocks only these lines which need to be decoded and further which can be decoded. All other lines will not be divided into subblocks, thus leading to a reduced number of lines which has to be divided into subblocks. Therefore it is possible to divide the ADT and iFDT or ADST and FDST into less subblocks, so that less decoder passes are needed.

If one or more lines cannot be decoded the rest of the table is not discarded: the process continues with the rest of the table. Actually the purpose is to decode as much as possible so that it is possible to recover as much as possible data when filing out the output ADST (there are B ADSTs at the output).

In other words a line needs to be decoded when there is an error at least in one position of the ADT or ADST part of this line and a line can be decoded when the total number of errors present in the entire line (namely the ADT and iFDT part or the ADST and FDST part of this line) is $\leq N$, N being the number of columns of the iFDT or FDST respectively.

The last mentioned method steps can be denominated as "Enhanced Block Decoding".

The number of lines T' issued from the error check will thus be smaller or equal to the parameter "T" $(T'): T' \leq T$.

The Enhanced Block Decoding mechanism then considers only those lines and divides them into sub-blocks.

$$N_{lines} = T / N_{blocks}$$

where $T$ is the parameter "T" of the Receiver, $N_{blocks}$ the maximum number of blocks considered and $N_{lines}$ the resulting number of lines per block.

$$N'_{blocks} = \left\lceil T' / N_{lines} \right\rceil ,$$

where $\lceil \rceil$ is the ceil function and $N'_{blocks}$ the resulting number of blocks. In the last sub-block to be processed the number of lines $N'_{lines}$ is smaller or equal to the number of lines per block:

$$N'_{lines} \le N_{lines} .$$

This results into having:

$$N'_{blocks} \le N_{blocks}$$

since T'$\le$ T, meaning that the number of decoder passes needed to process the ADT / iFDT is smaller or equal to the number of decoder passes using the Block Decoding mechanism.

The mechanisms proposed by now are:

- Utilization of a mechanism to increase performances using decoding based on blocks,
- Utilization of a mechanism to reduce the processing time using decoding based on blocks.

The two mechanisms proposed here aim at improving the performances of the MPE-iFEC Receiver by considering decoding based on blocks. E.g. the Reed-Solomon decoder remains the same knowing that it is able to decode sets ADT / iFDT having different size in terms of number of rows / lines (parameter "T").

The first mechanism called "Block Decoding" consists in dividing the ADT / iFDTS into sub-blocks and in processing each sub-block. By increasing the number of passes the capacity of the Receiver to recover from errors increases. On the other hand the processing time necessary is also increased and is directly related to the number of blocks considered.

The second mechanism called "Enhanced Block Decoding" reduces the number of passes by selecting the lines that can be decoded and dividing those lines into blocks. This decreases the overall number of lines to be decoded and thus the number of blocks to be processed. The mechanism offers the same performance as the Block Decoding considering the same number of blocks. The number of passes is reduced but the efforts of implementation are more important.

Another preferred embodiment of the invention contains the steps of checking the error patterns of the lines of the ADT and iFDT or ADST and FDST and gathering lines having the same error pattern into one subblock so that one subblock contains preferably only lines having the same error pattern.

Thus it is preferred that the number n of subblocks into which the ADT and iFDT or ADST and FDST are divided is the number of different error patterns found in these tables. This mechanism is denominated as "error pattern matching".

Another preferred embodiment of the present invention is characterized by the steps of associating or gathering subblocks which have less erroneous columns than the number of columns N of the iFDT or FDST respectively, such that the subblocks which have been associated have a total number of erroneous columns which is smaller than the number of columns N of the iFDT or FDST respectively. This mechanism is denominated as "block optimization" and aims at optimizing the blocks while preferably matching the error patterns. The purpose of the optimization is to reduce as much as possible the number of blocks, i.e. the number of times the decoder will be triggered during one bursts. Some blocks may have enough columns that are error free, so that they can be associated with other blocks. In any case the number of final columns with errors should stay below N so that the decoding process can be performed on the final block.

It is preferred to associate the subblocks such that their total number of erroneous columns reaches the number of columns of the iFDT or FDST (namely N ) as close as possible. In other words it is preferred to gather or associate these subblocks that will lead to the maximum possible number of total errors without exceeding the upper threshold of N.

If associating consecutive subblocks would lead the same maximum possible number of erroneous columns below or equal to the threshold N as it would be the case if associating non-consecutive subblocks, the consecutive subblocks are associated instead of the non-consecutive ones.

Another preferred embodiment of the present invention resides in defining an upper threshold for the maximum number of subblock into which the ADT and iFDT or ADST and FDST are divided whereby if the number of subblocks for obtaining the optimal decoding performance exceeds this upper threshold one or a plurality of subblocks are removed until the number of subblocks falls below this upper threshold again. The "removed" subblocks will thus not be decoded, i. e. the lines present in the subblocks will not be decoded. This means that errors will still be present at the output. This mechanism can be used just to be sure that the number of passes will not exceed a given threshold.

The last mentioned method step is denominated as "limiting passes". The purpose of this step is to reduce the number of decoding process passes per burst. Actually the number of decoding passes the MPE-iFEC receiver can perform directly depends on the processing power. Therefore it is useful to set a threshold so that the final number of blocks to be decoded cannot be greater than this threshold. If the number of blocks to be processed once the block optimization steps are finished is already below the threshold then there is no need to remove blocks.

It is further preferred to determine the size of the subblocks and to remove the smallest subblocks (in terms of number of lines) until the number of subblocks falls below the upper threshold. Decoding bigger blocks will increase the number of lines recovered in the ADT/iFDT and thus the performance of the MPE-iFEC receiver.

Thus the last mentioned method steps according to the invention can be described as "Smart Block Decoding" and have in common that mechanisms are utilized to increase the performance by these smart decoding steps. The decoder remains the same knowing that it is able to decode sets of ADT/iFDT (or ADST and FDST) having different sizes in terms of rows/lines (parameter T).

The results obtained from different simulations show that the Smart Block Decoding mechanism delivers optimal performances, i.e. the same performances as the ones obtained while decoding the ADT / iFDT line-by-line. Moreover the Smart Block Decoding mechanism limits significantly the number of passes and thus the processing time necessary to reach the optimal performances.

In the following preferred embodiments of the invention are described in the context of the figures.

Figure 1    shows a mapping example of a burst in ADST and iFDST according to the state of the art,

Figure 2    shows the mapping of the burst in ADST and iFDST using a padding according to the state of the art,

Figure 3    shows an example of the column status in the mapping of the burst in ADST and iFDST according to the state of the art,

Figure 4    shows the mapping of the ADST and iFDST into ADT's and iFDT's,

Figure 5    is a first example of the impact of the error pattern on decoding,

Figure 6    is an example of Block Decoding according to a first embodiment of the invention applied on the error pattern according to figure 5,

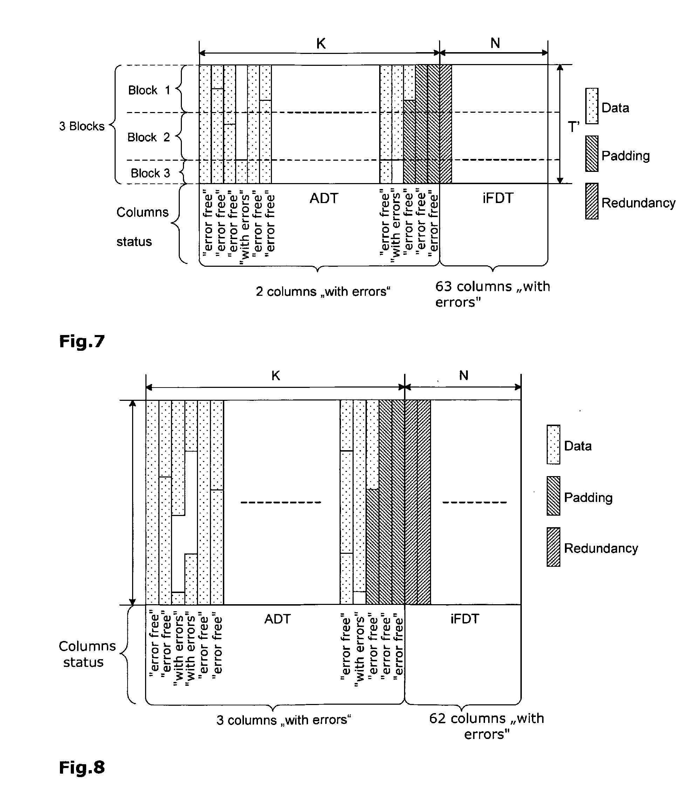

Figure 7    is an example of Enhanced Block Decoding according to a second embodiment of the invention applied on the error pattern of figure 5,

Figure 8    is a second example showing the impact of the error pattern on decoding,

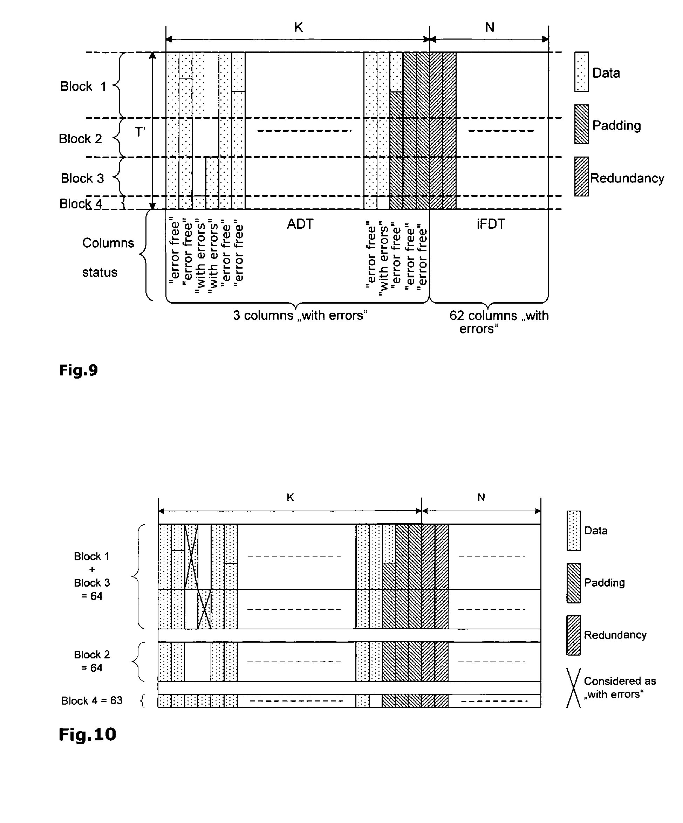

Figure 9    is an example of error pattern matching according to a third embodiment of the invention as it is applied on the error pattern of figure 8,

Figure 10    is an example of the block optimization according to a fourth embodiment of the invention as it is applied on the error pattern of figure 8,

Figure 11    is a schematic overview of a simulation which has been performed,

Figures 12 and 13    show the impact of the error probability on the Block Decoding mechanism for dump ID 1 and dump ID 2 respectively.

Figures 14 and 15    show the performances of the Block Decoding and Enhanced Block Decoding mechanisms for dump ID 1 and dump ID 2 respectively for a first simulation.

Figures 16 and 17    show the performances of the Smart Block Decoding mechanism for dump ID 1 and dump ID 2 respectively according to a second simulation.

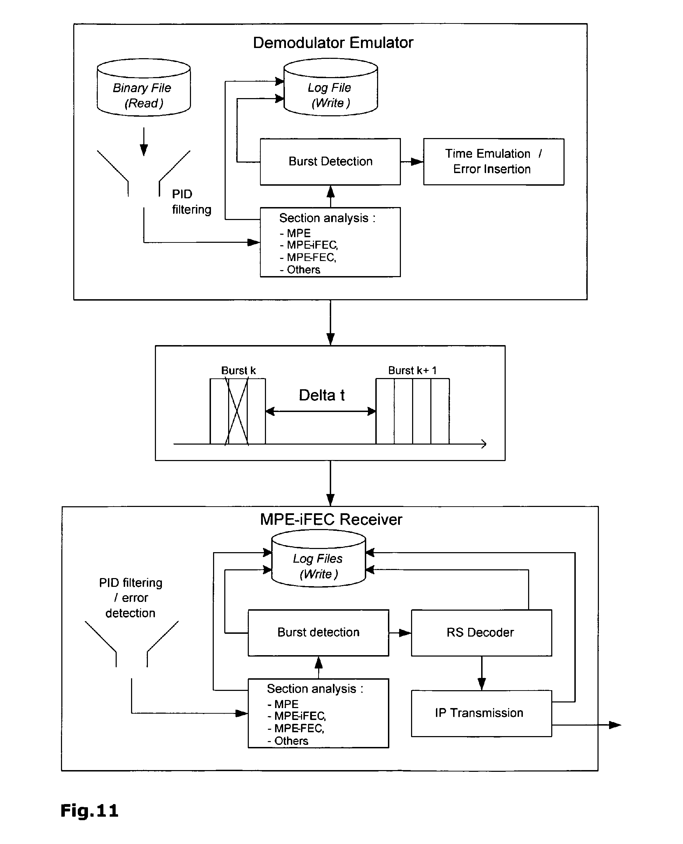

Simulations were performed using a Demodulator Emulator and the MPE-iFEC Receiver. The Demodulator Emulator reads as input a file containing a dump performed at the transport stream level (MPEG-TS packets). It considers the elementary stream (ES) of interest based on the MPEG-TS PID field. It can reproduce the time behavior of the bursts, i.e. data is transmitted during the burst duration but not between the end of a given burst (last byte) and the start of the next burst (first byte). For this purpose the Demodulator Emulator analyses the input stream. The Demodulator Emulator can introduce transmission errors which consist in setting the Transport Stream error indicator (field named "TS_error_ind") of the MPEG-TS header to "1" (1 = FEC error). Two kinds of errors can be simulated: random errors with a given probability and / or burst errors. Random errors consist in selecting randomly the MPEG-TS packets of the ES and setting the error flag. Burst errors consist in setting the flags of all MPEG-TS packets containing the MPE sections of the selected bursts to "1". Actually the burst numbers to be deleted are provided by the configuration file. Figure 11 depicts the Testbed architecture used for the simulations.

It has to be remarked that the different input files used to perform the simulations are fully compliant with the standard and do not contain errors. The payload of the MPE sections contains IP packet having various sizes.

Different configurations were used in order to verify the performances of the MPE-iFEC Receiver. The following parameters are mainly affected:

- T: the symbol size of code (number of rows in ADST/iFDST/ADT/iFDT)
- C: the maximum number of data columns per ADST
- R: the maximum number of iFEC sections in an iFEC burst
- B: the iFEC data interleaving (number of matrices over which data is interleaved)
- S: the iFEC spread (number of matrices over which redundancy is interleaved)
- D: data delay at sender

For all the configurations and since the Reed-Solomon decoder is considered:

- EP: the encoding period MUST be set to 1.
- G: the maximum number of symbols per MPE-iFEC section MUST be set to 1.

Leading to the following:

- K: the number of columns per ADT is equal to $K = EP \times C = C$
- N: the number of columns per iFDT is equal to $N = EP \times R \times G = R$

The next parameters are obtained based on the value of B, S, and D:

- $M = B + max(0, S - D) + max(0, D - B)$
- $kMax = 256 - 256[M]$

The next table (Table 1,) summarizes the dumps and the corresponding configurations considered for the simulations. The three last columns indicate respectively how many bursts are present in the dump, the first burst ID detected and the total number of IP packets in the dump.

Table 1: List of dumps and corresponding configurations considered for the simulations.

| Dumps ID | Receiver Parameters | | | | | | | Bursts | | IP |
|---|---|---|---|---|---|---|---|---|---|---|
| | PID | T | C | R | B | S | D | # | First ID | Total |
| 1 | 101 | 512 | 120 | 52 | 17 | 8 | 0 | 614 | 113 | 38172 |
| 2 | 105 | 768 | 120 | 52 | 17 | 8 | 0 | 615 | 63 | 48178 |

For all the simulations performed on the two PIDs the following burst erasure was considered:

- PID 101: burst IDs 160, 164, 170 and 171.
- PID 105: burst IDs 100, 104, 110 and 111.

Next the impact of the error probability is explained.

The next tables (Table 2 and Table 3) give the results from the simulations performed on the MPE-iFEC Receiver respectively with the PID 101 and the PID 105 while modifying the error probability (MPEG-TS). The second column of the tables indicates the total number of columns "with errors" in the ADT / iFDT to be processed. Actually before each decoding process a set of ADT / iFDT is selected. The next columns ("1 Block") indicate the number of columns recovered by the decoding process and the corresponding percentage using a single block. Processing a single block corresponds to processing the ADT / iFDT once (standard MPE-iFEC Receiver). The next two columns ("512 Blocks" in Table 2 and "768 Blocks" in Table 3) give the same information but when processing the ADT / iFDT line-by-line (the number of blocks is equal to the parameter "T"). The results can be interpreted as the standard MPE-iFEC Receiver (1 block) versus the one implementing the Block Decoding mechanisms (512 blocks / 768 blocks) for different error probabilities.

Table 2: Dump ID 1: impact of the error probability on the Block Decoding mechanism.

| PID 101 | ADT/iFDT | 1 Block | | 512 Blocks | | Difference | |
| --- | --- | --- | --- | --- | --- | --- | --- |
| | Errors | Columns | | Columns | | Columns | |
| Error Prob. | Columns | # | % | # | % | # | % |
| 1% | 19198 | 16953 | 88.31% | 16951 | 88.31% | -2 | 0.00% |
| 2% | 26641 | 23544 | 88,38% | 24078 | 90.38% | 534 | 2.00% |
| 3% | 33417 | 28085 | 84.04% | 29069 | 86.99% | 984 | 2.85% |
| 4% | 39528 | 23129 | 58.51% | 30754 | 77.80% | 7625 | 19.29% |
| 5% | 45183 | 5982 | 13.24% | 22476 | 49.74% | 16494 | 36.50% |
| 6% | 50362 | 303 | 0,60% | 6392 | 12,69% | 6089 | 12.09% |
| 7% | 55112 | 0 | 0.00% | 546 | 1.00% | 546 | 1.00% |
| 8% | 59319 | 0 | 0.00% | 6 | 0.01% | 6 | 0.01% |
| 9% | 63130 | 0 | 0,00% | 0 | 0.00% | 0 | 0.00% |

Table 3: Dump ID 2: impact of the error probability on the Block Decoding mechanism.

| PID 105 | ADT/iFDT | 1 Block | | 768 Blocks | | Difference | |
| --- | --- | --- | --- | --- | --- | --- | --- |
| | Errors | columns | | Columns | | Columns | |
| Error Prob. | Columns | # | % | # | % | # | % |
| 1% | 21033 | 18791 | 89.34% | 18792 | 89.35% | 1 | 0.01% |
| 2% | 29824 | 25367 | 85.06% | 26724 | 89.61% | 1357 | 4.55% |
| 3% | 37839 | 26483 | 69.99% | 31286 | 82.68% | 4803 | 12.69% |
| 4% | 44875 | 7206 | 16.06% | 29306 | 65,31% | 22100 | 49.25% |
| 5% | 51342 | 189 | 0.37% | 8237 | 16.04% | 8048 | 15.67% |
| 6% | 56954 | 0 | 0,00% | 733 | 1.29% | 733 | 1.29% |
| 7% | 62117 | 0 | 0.00% | 8 | 0.01% | 8 | 0.01% |
| 8% | 66642 | 0 | 0.00% | 0 | 0.00% | 0 | 0.00% |
| 9% | 70779 | 0 | 0,00% | 0 | 0.00% | 0 | D,DD% |

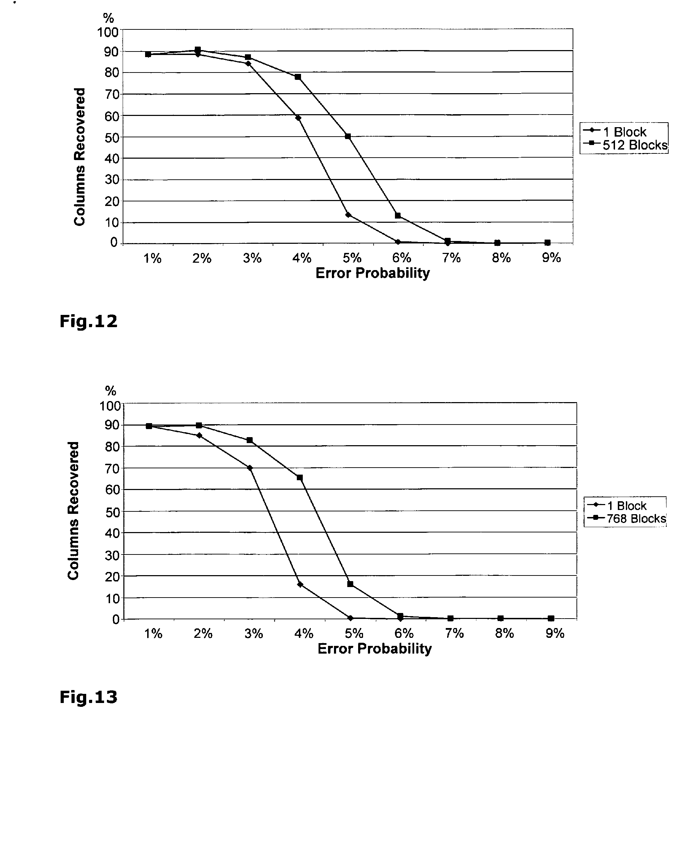

Figure 12 and Figure 13 show the performance of the MPE-iFEC Receiver in terms of column recovery (percentage). For each simulated error probability one can see the improvement using higher number of blocks. The improvement is represented by the distance between the two curves and is maximal when the error probability is 5% and 4% respectively for the PID 101 and the PID 105. In the first case (5% and PID 101) the number of columns recovered is about 50% instead of 13% (gain of about 37%). In the second case (4% and PID 105) the number of columns recovered is about 65% instead of 16% (gain of about 49%). Processing the ADT / iFDT in one shot (1 block) thus provides bad performance compared to processing the ADT / iFDT line-by-line (512 blocks / 768 blocks). Using "T" blocks will offer the best performances.

Simulations were performed for Block Decoding and enhanced Block Decoding using both dumps as input (PID 101 and PID 105). For the first dump the error probability was set to 6% which is the last case before the MPE-iFEC Receiver cannot decode anymore while using 1 block (see Table 2). For the second dump the error probability was set to 4°/° which should provide the best improvement (see Table 3). The erasure pattern at the burst level is the same as the one used for the previous simulations. The results obtained are given by the next tables (Table 4 and Table 5). The first column indicates the maximum number of blocks considered. Using the Block Decoding mechanism this number corresponds directly to the number of sub-blocks. For instance if the maximum blocks is set to 256 then there will be 256 blocks processed for each set of ADT / iFDTs, all blocks having two lines and three lines respectively for the PID 101 (T = 512) and the PID 105 (T = 768). As specified before the Enhanced Block Decoding mechanism aims at reducing the number of passes. The number of passes is thus recorded for both mechanisms, The number of passes using the Block Decoding mechanism corresponds to the number of burst present in the dump multiplied by the number of blocks processed. On the other hand the number of passes obtained using the Enhanced Block Decoding directly depends on the number of lines that can be decoded each time a set of ADT / iFDT is processed.

Table 4: Dump ID 1: impact of the error probability on the Block Decoding mechanism.

| | Block Decoding | | | Enhanced Block Decoding | | | | |
| | Columns | | Passes | Columns | | Passes | | |
| Max Blocks | # | % | # | # | % | # | Per Burst | % |
| --- | --- | --- | --- | --- | --- | --- | --- | --- |
| 1 | 303 | 0.60% | 614 | 303 | 0.60% | 288 | 0.47 | 53.09% |
| 2 | 2173 | 4.32% | 1228 | 2190 | 4.35% | 469 | 0.76 | 61.81% |
| 4 | 4362 | 8.66% | 2456 | 4370 | 8,68% | 825 | 1.34 | 66,41% |
| 8 | 5521 | 10,96% | 4912 | 5523 | 10,97% | 1540 | 2,51 | 68,65% |
| 16 | 6027 | 11,97% | 9824 | 6019 | 11,95% | 2977 | 4,85 | 69,70% |
| 32 | 6138 | 12,19% | 19648 | 6136 | 12,18% | 5850 | 9,53 | 70,23% |
| 64 | 6299 | 12.51% | 39296 | 6305 | 12.52% | 11595 | 18,88 | 70,45% |
| 128 | 6309 | 12.53% | 78592 | 6318 | 12,55% | 23085 | 37,60 | 70,63% |
| 256 | 6379 | 12,67% | 157184 | 6386 | 12,68% | 46073 | 75.04 | 70,69% |
| 512 | 6392 | 12,69% | 314368 | 6392 | 12,69% | 92044 | 149.91 | 70,72% |

Table 5: Dump ID 2: impact of the error probability on the Block Decoding mechanism.

| | Block Decoding | | | Enhanced Block Decoding | | | | |
| | Columns | | Passes | Columns | | Passes | | |
| Max Blocks | # | % | # | # | % | # | Per Burst | % |
| --- | --- | --- | --- | --- | --- | --- | --- | --- |
| 1 | 7206 | 16.06% | 615 | 7206 | 16.06% | 530 | 0,86 | 13,82% |
| 2 | 18347 | 40,89% | 1230 | 18376 | 40,95% | 1031 | 1,68 | 16,18% |
| 4 | 23376 | 52,09% | 2460 | 23379 | 52.10% | 2024 | 3.29 | 17,72% |
| 8 | 26826 | 59.78% | 4920 | 26833 | 59.80% | 4006 | 6.51 | 18,58% |
| 16 | 28223 | 62.90% | 9840 | 28208 | 62,86% | 7972 | 12.96 | 18,98% |
| 32 | 28803 | 64.19% | 19680 | 28800 | 64,18% | 15898 | 25,85 | 19,22% |
| 64 | 28967 | 64,55% | 39360 | 28970 | 64,56% | 31746 | 51.62 | 19,34% |
| 128 | 29233 | 65,15% | 78720 | 29234 | 65,15% | 63439 | 103.15 | 19,41% |
| 256 | 29301 | 65,30% | 157440 | 29302 | 65,30% | 126823 | 206.22 | 19,45% |

(continued)

| Max Blocks | # | % | # | # | % | # | Per Burst | % |
|---|---|---|---|---|---|---|---|---|
| 384 | 29304 | 65,30% | 236160 | 29303 | 65,30% | 190158 | 309.20 | 19,48% |
| 768 | 29306 | 65,31% | 472320 | 29306 | 65,31% | 379922 | 617.76 | 19,56% |

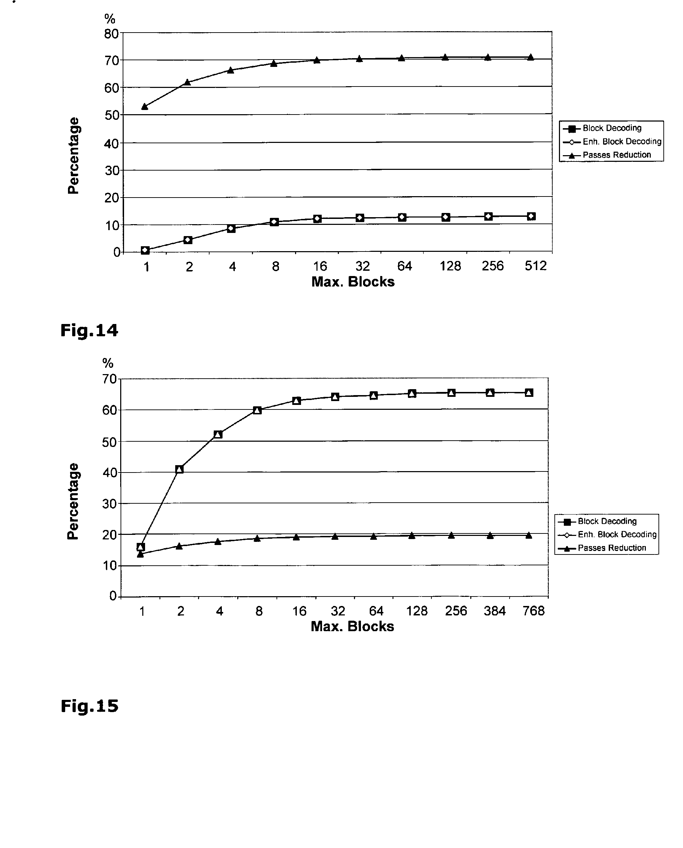

Figure 14 and Figure 15 depict the results obtained. For both dumps the two curves showing the capacity of the MPE-iFEC Receiver to recover columns for the Block Decoding mechanism and the Enhanced Block Decoding are superimposed. The two mechanisms offer exactly the same performances. The higher the number of blocks, the better the performances are. On the other hand the number of passes necessary using the Enhanced Block Decoding is dramatically reduced: about 70% and 20% passes less for big numbers of blocks to get the same performances respectively for the PID 101 and the PID 105.

On one side the Block Decoding offers good performances but requires more processing time (number of passes needed). One can see that considering smaller amount of blocks (subblocks) provides almost the same performances as the highest number of blocks (for instance 32 blocks instead of 512 / 768). The Block Decoding mechanism does not require too much implementation efforts but the number of blocks that can be considered depends on the capability of the MPE-iFEC Receiver. When the number of subblocks is too high then the Block Decoding mechanism will require too much processing time impacting the capacity of the Receiver to decode in real-time.

On the other side the Enhanced Block Decoding permits to reduce the number of passes needed and thus the processing time. A MPE-iFEC Receiver with a given capacity in terms of processing power can consider higher number of blocks using the Enhanced Block Decoding. For instance if the Receiver cannot perform more than 10 passes per burst then this leads to a maximum number of blocks equal to 8 considering the Block Decoding mechanism and a number of blocks equal to 32 considering the Enhanced Block Decoding mechanism (valid for the PID 101 only). However the efforts are more important for implementing the Enhanced Block Decoding mechanism.

In another simulation performed on the two PIDs according to table 1 the following error probability and burst erasure were considered:

　　o Dump ID 1 / PID 101: error probability 6% and burst IDs 160, 164, 170 and 171.
　　o Dump ID 2 / PID 105: error probability 4% and burst IDs 100, 104, 110 and 111.

When the Smart Block Decoding mechanism is not enabled, i.e. when using the standard MPE-iFEC Receiver, the number of columns recovered by the RS decoder is:

　　o Dump ID 1 / PID 101: 303 (0.60%)
　　o Dump ID 2 / PID 105: 7206 (16.06%)

In that case the whole set of ADT / iFDT is processed once by the RS decoder as a single block having T lines / rows.

Table 6 and Table 7 give the results of the simulations respectively for the dump ID 1 and the dump ID 2. In both tables the first column indicates the maximum number of blocks considered. The maximum number of blocks corresponds to the limitation of passes, i.e. to the maximum number of decoding processes during one burst. The second column indicates the corresponding maximum number of passes for the whole simulation. The third column contains the number of columns "with errors" in the ADT / iFDT before starting decoding and remains the same during all the simulations (same seed considered). The two next columns give the number of columns recovered after decoding and the corresponding percentage. The next three and last columns contain information about the decoder passes: first the number of passes, then the average number of passes per burst and finally the corresponding reduction according to the maximum number of passes.

As can be seen in both cases (dump ID 1 and 2) the number of recovered columns does not increase anymore when the maximum number of blocks is above 32. This indicates that the Smart Block Decoding mechanism is able to optimize the blocks so that the number of blocks does not exceed 32.

Table 6: Dump ID 1: Performances of the Smart Block Decoding mechanism.

| | Standard | ADT/iFDT | Smart Block Decoding | | | | |
| --- | --- | --- | --- | --- | --- | --- | --- |
| | Max Passes | Errors | Columns | | Passes | | |
| Max Blocks | # | Columns | # | % | # | Per Burst | % |
| 1 | 614 | 50362 | 60 | 0,12% | 288 | 0,47 | 53,09% |
| 2 | 1228 | | 146 | 0,29% | 557 | 0,91 | 54,64% |
| 4 | 2456 | | 751 | 1,49% | 1065 | 1,73 | 56,64% |
| 8 | 4912 | | 4677 | 9,29% | 1798 | 2,93 | 63,40% |
| 16 | 9824 | | 6370 | 12,65% | 2168 | 3.53 | 77,93% |
| 32 | 19648 | | 6392 | 12,69% | 2187 | 3,56 | 88,87% |
| 64 | 39296 | | 6392 | 12,69% | 2187 | 3,56 | 94,43% |
| 128 | 78592 | | 6392 | 12,69% | 2187 | 3,56 | 97,22% |
| 256 | 157184 | | 6392 | 12,69% | 2187 | 3,56 | 98,61% |
| 512 | 314368 | | 6392 | 12,69% | 2187 | 3,56 | 99,30% |

Table 7: Dump ID 2: Performances of the Smart Block Decoding mechanism.

| | Standard | ADT/iFDT | Smart Block Decoding | | | | |
| --- | --- | --- | --- | --- | --- | --- | --- |
| | Max Passes | Errors | Columns | | Passes | | |
| Max Blocks | # | Columns | # | % | # | Per Burst | % |
| 1 | 615 | 44875 | 218 | 0.49% | 530 | 0,86 | 13,82% |
| 2 | 1230 | | 591 | 1,32% | 1056 | 1,72 | 14,15% |
| 4 | 2460 | | 3755 | 8,37% | 2099 | 3,41 | 14,67% |
| 8 | 4920 | | 22359 | 49,83% | 3507 | 5,70 | 28,72% |
| 16 | 9840 | | 29091 | 64,83% | 4094 | 6,66 | 58,39% |
| 32 | 19680 | | 29306 | 65,31% | 4116 | 6,69 | 79,09% |
| 64 | 39360 | | 29306 | 65,31% | 4116 | 6,69 | 89,54% |
| 128 | 78720 | | 29306 | 65,31% | 4116 | 6,69 | 94,77% |
| 256 | 157440 | | 29306 | 65,31% | 4116 | 6,69 | 97,39% |
| 384 | 236160 | | 29306 | 65,31% | 4116 | 6,89 | 98,26% |
| 768 | 472320 | | 29306 | 65,31% | 4116 | 6,69 | 99,13% |

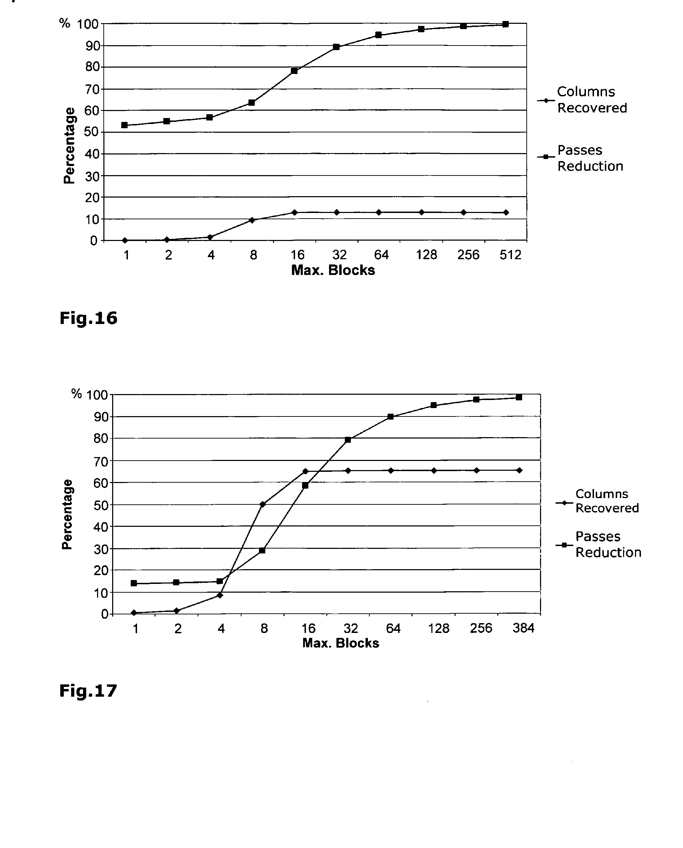

The two graphs shown in figure 16 and figure 17 show both the percentage of columns recovered by the RS decoder and the reduction of passes. One can see again that the number of columns recovered does not increase anymore after setting a maximum number of blocks above 32. The percentages of columns recovered were 0.60% and 16.06% without Smart Block Decoding mechanism respectively for the dump ID 1 and the dump ID 2. The improvements obtained using the Smart Block Decoding mechanism are thus 12.09% and 49.25% respectively. Such improvements would be obtained without the Smart Block Decoding mechanism if the decoding process was performed line-by-line on the ADT / iFDT meaning that the numbers of passes would be 314 368 and 472 320 respectively for the PID 101 and the PID 105. Using the Smart Block Decoding thus permits to reach the optimal performances and also to reduce dramatically the number of passes (about 99% on both dumps).

The following abbreviations have been used in the present application:

ADST          Application Data Sub Table

ADT      Application Data Table

DVB      Digital Video Broadcasting

DVB-SH    DVB - Satellite on Handheld

DVB-T    DVB - Terrestrial

EP      Encoding Period

ES      Elementary Stream

FDST    FEC Data Sub Table

FEC     Forward Error Correction

iFDST    IFEC Data Sub Table

iFDT     iFEC Data Table

iFEC    Inter-burst FEC

IP      Internet Protocol

MPE     Multi Protocol Encapsulation

MPEG-TS  Motion Picture Expert Group -Transport Stream

PID     Program IDentifier

RS     Reed-Solomon

Each of the preferred embodiments of the invention can be realized in combination with one or more of the other preferred embodiments or without the features described in the context of the other embodiments. Thus each of the preferred embodiments is regarded as an independent invention.

**Claims**

1. Method of transmitting data from a transmitter to a receiver, in particular in a DVB-scenario, whereby data is transmitted in consecutive bursts and each burst comprises a plurality of Multi-Protocol Encapsulation (MPE) sections and additionally Multi-Protocol Encapsulation-inter-burst-Forward Error Correction (MPE-iFEC) sections and / or Multi-Protocol Encapsulation-Forward Error Correction (MPE-FEC) sections, whereby the content of the transmitted MPE-sections and MPE-iFEC or MPE-FEC sections is mapped into an Application Data Sub-Table (ADST) and an inter-burst-Forward Error Correction Data Sub-Table (iFDST) or Forward Error Correction Data Sub-Table (FDST) respectively, whereby the content of the ADST and iFDST is mapped into ADT's and iFDTS's respectively as far as MPE- and MPE-iFEC sections are concerned, the decoding process is applied on a particular set of ADT and iFDT for MPE- and MPE-iFEC sections and on the ADST and FDST for MPE- and MPE-FEC sections and after the decoding was performed on a particular set of ADT and iFDT the data part is copied back into ADST's **characterized in that** the ADT and iFDT or ADST and FDST on which decoding shall be applied is divided into several subblocks before being decoded, each subblock containing one or more lines of the ADT and iFDT or ADST and FDST, each subblock is then forwarded to the decoder, so that decoding is applied on this subblock, whereby the decoder computes the column status for each subblock, namely the total number of erroneous or missing columns in this subblock and decides whether the content of each subblock can be decoded or not based on the column status of this subblock.

EP 2 369 769 A2

2. Method of transmitting data, according to claim 1, **characterized in that** each subblock contains the same number of lines, which depends on the parameter T, namely the total size of the columns of the ADT and iFDT or ADST and FDST and further on the number n of subblocks considered.

3. Method of transmitting data, according to one of claims 1 or 2, **characterized in that** for decoding the entire ADT and iFDT or ADFT and FDST the decoding process is initiated n times, n being the number of subblocks considered.

4. Method of transmitting data, according to one of claims 1 or 3, **characterized by** the steps:

   checking the total number of errors in each line of the ADT and iFDT or ADST and FDST in order to decide if this line can be decoded or needs to be decoded,
   dividing into subblocks only the lines which need to be decoded and can be decoded.

5. Method of transmitting data, according to claim 4, **characterized in that** a line needs to be decoded when there is an error at least in one position of the ADT or ADST part of this line and a line can be decoded when the total number of errors present in the entire line is ≤N, N being the number of columns of the iFDT or FDST respectively.

6. Method of transmitting data, according to one of claims 1-5, **characterized by** the steps:

   checking the error patterns of the lines of the ADT and iFDT or ADST and FDST,
   gathering lines having the same error pattern into one subblock, so that one subblock contains preferably only lines having the same error pattern.

7. Method of transmitting data, according to claim 6, **characterized in that** the number n of subblocks into which the ADT and iFDT or ADST and FDST are divided is the number of different error patterns found in the matrix to be decoded.

8. Method of transmitting data, according to one of claims 1-7, **characterized by** the steps:

   associating subblocks which have less erroneous columns than the number of columns N of the iFDT or FDST respectively such that the subblocks which have been associated have a total number of erroneous columns which is smaller than the number of columns N of the iFDT or FDST respectively.

9. Method of transmitting data, according to claim 8, **characterized in that** the subblocks are associated such that their total number of erroneous columns reaches the number of columns N of the iFDT or FDST respectively as close as possible.

10. Method of transmitting data, according to one of claims 8 or 9, **characterized in that** if associating consecutive subblocks would lead to the same maximum possible number of erroneous columns below or equal to the threshold N as it would be the case if associating non-consecutive subblock, the consecutive subblocks are associated instead the non-consecutive ones.

11. Method of transmitting data, according to one of claims 1-10, **characterized by** the steps:

   defining an upper threshold for the maximum number of subblocks into which the ADT and iFDT or ADST and FDST are divided,
   whereby if the number of subblocks for obtaining the optimal decoding performance exceeds this upper threshold one or a plurality of subblocks are removed, until the number of subblocks falls below this upper threshold.

12. Method of transmitting data, according to claim 11, **characterized by** the steps:

   determining the size of the subblocks,
   removing the smallest subblocks until the number of subblocks falls below the upper threshold.

14

Data

--- K-1 ----· K --- K+1

Time

Process burst K

Buffer containing
The section of
Burst K

MPE @a3
iFEC SN2
MPE @a2
MPE @a1
iFEC SN 0

C

R

T

ADST

iFDST

**Fig.1**

C

Size of burst K

T

Data

Padding

ADST

Padding

MPE section lost

**Fig.2**

MPE section lost          MPE-iFEC section lost

C (ADST)                    R (iFDST)

Columns status

**Fig.3**

C (ADST)    R (iFDST)

ADT    iFDT

M

**Fig.4**

Fig.5

Fig.6

**Fig.7**

**Fig.8**

Fig.9

Fig.10

## Demodulator Emulator

Binary File
(Read)

Log File
(Write)

PID
filtering

Burst Detection

Time Emulation /
Error Insertion

Section analysis :
- MPE
- MPE-iFEC,
- MPE-FEC,
- Others

Burst k

Burst k+ 1

Delta t

## MPE-iFEC Receiver

PID filtering
/ error
detection

Log Files
(Write)

Burst detection

RS Decoder

Section analysis :
- MPE
- MPE-iFEC,
- MPE-FEC,
- Others

IP Transmission

## Fig.11

**Fig.12**

**Fig.13**

**Fig.14**

**Fig.15**

**Fig.16**

**Fig.17**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- Digital Video Broadcasting (DVB); DVB specification for data broadcasting. *ETSI EN 301 192 V1.4.2,* April 2008, vol. 1.4.2
- Framing structure, channel coding and modulation for digital terrestrial television. *ETSI EN 300 744 V1,6.1,* January 2009, vol. 1,6.1
- Framing Structure, channel coding and modulation for Satellite Services to Handheld devices (SH) below 3 GHz. *ETSI EN 302 583 V1.1.1,* July 2007

- Guidelines for Implementation for Satellite Services to Handheld devices (SH) below 3GHz. *ETSI TS 102 584 V1.1.1,* December 2008, vol. 1.1.1
- Draft TS 102 772 V1.1.1. DVB BlueBook A131. November 2008
- MPE-IFEC, Draft TS 102 772 V1.1.1. DVB BlueBook A131. November 2008